# EUROPEAN PATENT APPLICATION

(11) **EP 4 601 433 A1**
(43) Date of publication of application: **13.08.2025**
(21) Application number: 25155761.7
(22) Date of filing: 04.02.2025
(51) Int. Cl.: H10D 84/01, H10D 30/01, H10D 30/00, H10D 84/83, H10D 84/85, H10D 88/00

(54) **FORKSHEET STACKED TRANSISTOR STRUCTURE HAVING MIDDLE ISOLATION REGION, AND RELATED FABRICATION METHOD**

(30) Priority: 05.02.2024 US 202463549686 P; 03.07.2024 US 202418762787
(71) Applicant: Samsung Electronics Co., Ltd., Suwon-si, Gyeonggi-do 16677 (KR)
(72) Inventor: YANG, Myung, San Jose, CA, 95134 (US); LEE, Jaehong, San Jose, CA, 95134 (US); SEO, Kang-lll, San Jose, CA, 95134 (US); SONG, Seungmin, San Jose, CA, 95134 (US)
(74) Representative: Kuhnen & Wacker Patent- und Rechtsanwaltsbüro PartG mbB

(57) **Abstract**

Forksheet stacked field-effect transistor (FET) devices are provided. A forksheet stacked FET device includes a first stacked FET (116a) having a first lower FET (LTa) and a first upper FET (UTa). The forksheet stacked FET device includes a second stacked FET (116b) that is adjacent the first stacked FET (116a). The second stacked FET (116b) has a second lower FET (LTb) and a second upper FET (UTb). The forksheet stacked FET device includes a dielectric wall (134) that is between the first lower FET (LTa) and the second lower FET (LTb). The forksheet stacked FET device includes a middle isolation region (136) having a first portion that is between the first lower FET (LTa) and the first upper FET (UTa), and a second portion that is between the second lower FET (LTb) and the second upper FET (UTb). Related methods of forming stacked FET devices are also provided.

## Description

### TECHNICAL FIELD

The present disclosure generally relates to the field of semiconductor devices and, more particularly, to three-dimensional (3D) transistor structures.

### BACKGROUND OF THE INVENTION

The size of transistors in integrated circuit (IC) devices has continued to decrease to down-scale logic elements. This has resulted in the development of gate-all-around (GAA) structures such as multi-bridge channel field-effect transistors (MBCFETs^{™}) and nanosheet FETs (NSFETs). Moreover, as technology to increase transistor density has continued to develop, 3D device structures, such as stacked transistors, are under consideration.

A stacked transistor (or "transistor stack") may include a first transistor and a second transistor. The first transistor may be a first type of transistor (e.g., an n-type metal-oxide-semiconductor (NMOS) transistor), and the second transistor may be a second type of transistor (e.g., a p-type metal-oxide-semiconductor (PMOS) transistor). The first and second types of transistors may be complementary to each other, and thus may be part of a complementary metal-oxide-semiconductor (CMOS) IC. The first and second transistors may be stacked vertically in any order (e.g., first on top of second, or second on top of first), thereby resulting in a stack comprising a top/upper transistor and a bottom/lower transistor.

Another type of device structure under consideration is a forksheet transistor. The forksheet transistor may include a first transistor and a second transistor that are horizontally side by side. The first transistor may be a first type of transistor (e.g., an n-type FET), and the second transistor may be a second type of transistor (e.g., a p-type FET). The first and second transistors may be horizontally separated from each other on opposing sides of a dielectric wall, which may allow for reduced spacing.

### SUMMARY OF THE INVENTION

A forksheet stacked FET, according to some embodiments herein, may include a first stacked FET having a first lower FET and a first upper FET that is on top of the first lower FET. The forksheet stacked FET may include a second stacked FET that is adj acent the first stacked FET. The second stacked FET may include a second lower FET and a second upper FET that is on top of the second lower FET. The forksheet stacked FET may include a dielectric wall that is between the first lower FET and the second lower FET. The forksheet stacked FET may include a first middle dielectric isolation (MDI) region that is between the first lower FET and the first upper FET. Moreover, the forksheet stacked FET may include a second MDI region that is between the second lower FET and the second upper FET.

A forksheet stacked FET, according to some embodiments herein, may include a first stacked FET having a first lower FET and a first upper FET that is on top of the first lower FET. The forksheet stacked FET may include a second stacked FET that is adjacent the first stacked FET in a horizontal direction. The second stacked FET may include a second lower FET and a second upper FET that is on top of the second lower FET. The forksheet stacked FET may include a dielectric wall that is between, in the horizontal direction, the first lower FET and the second lower FET. The forksheet stacked FET may include a middle isolation region having a first portion that is between, in a vertical direction, the first lower FET and the first upper FET, and a second portion that is between, in the vertical direction, the second lower FET and the second upper FET. Moreover, the middle isolation region may be integral with the dielectric wall.

A method of forming a forksheet stacked FET device, according to some embodiments herein, may include forming a dielectric wall and a middle isolation region in a stack of semiconductor channel layers. Moreover, the method may include etching upper ones of the semiconductor channel layers while using a middle portion of the middle isolation region as an etch-stop layer. The dielectric wall may separate first lower semiconductor channel layers among lower ones of the semiconductor channel layers from second lower semiconductor channel layers among the lower ones of the semiconductor channel layers. A first outer portion of the middle isolation region may be between the first lower semiconductor channel layers and first upper semiconductor channel layers among the upper ones of the semiconductor channel layers. A second outer portion of the middle isolation region may be between the second lower semiconductor channel layers and second upper semiconductor channel layers among the upper ones of the semiconductor channel layers.

### BRIEF DESCRIPTION OF THE DRAWINGS

FIG. 1A is a schematic block diagram of a forksheet stacked FET structure of a transistor device according to some embodiments herein.
FIG. 1B is an example cross-sectional view of the forksheet stacked FET structure of FIG. 1A.
FIGs. 2A-2J are cross-sectional views illustrating operations of forming the forksheet stacked FET structure of FIG. 1B.
FIG. 3 is a flowchart corresponding to the operations shown in FIGs. 2A-2J.

### DETAILED DESCRIPTION

Pursuant to embodiments herein, a forksheet transistor structure may be combined with a stacked transistor structure. This combination provides a 3D device structure that can reduce an area of an IC device, and may be referred to herein as a "forksheet stacked" (or "stacked forksheet") transistor structure. The forksheet stacked transistor structure may be, for example, a forksheet stacked FET that includes a first upper FET stacked on a first lower FET and a second upper FET stacked on a second lower FET. The forksheet stacked FET can increase transistor density beyond the capability of a conventional (i.e., non-forksheet) stacked FET.

Though an MDI region can separate an upper FET from a lower FET in a stacked FET, over-etching of the upper FET can damage the MDI region and/or the lower FET. For example, etching upper channel layers of the upper FET to narrow a width of the upper channel layers can result in undesired rounding of (i) the MDI region, (ii) a lower sacrificial gate layer, and/or (iii) a lower channel layer of the lower FET.

Embodiments herein, however, provide forksheet stacked FET structures that (1) reduce/prevent damage to lower FETs and (2) include MDI regions that separate the lower FETs from upper FETs. As an example, the MDI regions may be part of a middle isolation region that includes an etch-stop layer that protects the lower FETs from damage. In some embodiments, the middle isolation region may be integral with a dielectric wall that separates a first lower FET of a forksheet stacked FET structure from a second lower FET of the forksheet stacked FET structure. The middle isolation region may be relatively easy to form, and can result in improved profiles (e.g., less rounding) of the MDI regions and/or the lower FETs.

Example embodiments will be described in greater detail with reference to the attached figures.

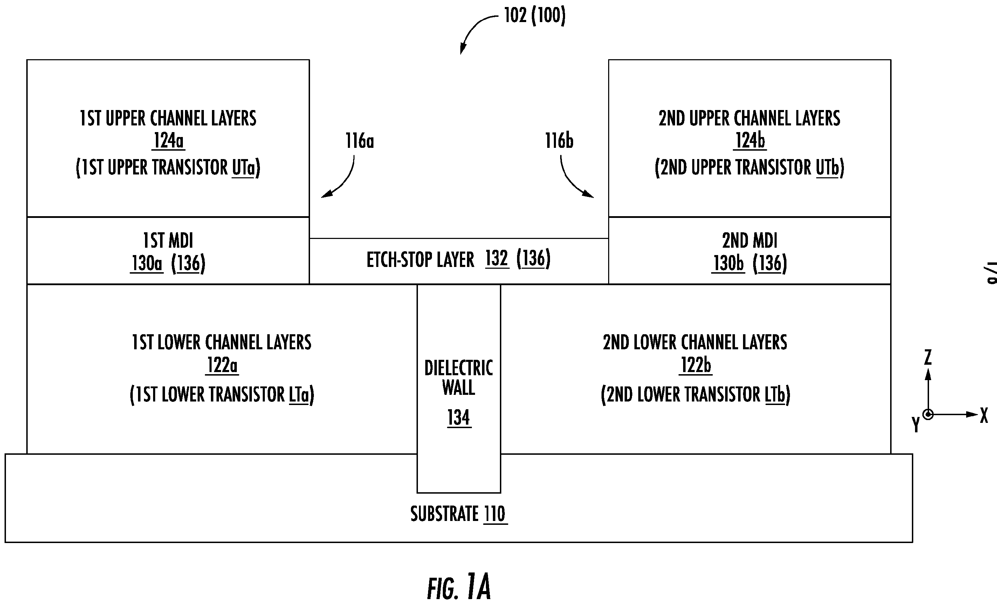

FIG. 1A is a schematic block diagram of a forksheet stacked FET structure 102 of a transistor (i.e., IC) device 100 according to some embodiments herein. The forksheet stacked FET structure 102 includes a first transistor stack (or "first stacked transistor") 116a and a second transistor stack (or "second stacked transistor") 116b. The first transistor stack 116a includes a first lower transistor LTa having a stack of first lower semiconductor channel layers 122a and a first upper transistor UTa having a stack of first upper semiconductor channel layers 124a. The second transistor stack 116b includes a second lower transistor LTb having a stack of second lower semiconductor channel layers 122b and a second upper transistor UTb having a stack of second upper semiconductor channel layers 124b. The channel layers 122 (122a, 122b), 124 (124a, 124b) may comprise, for example, silicon and may be free of germanium and carbon.

The first transistor stack 116a is adjacent the second transistor stack 116b in a first horizontal (i.e., lateral) direction X. As used herein with respect to two transistor stacks 116 (116a, 116b), the term "adjacent" means that no other transistor stack 116 intervenes between the two transistor stacks 116.

The first lower transistor LTa is between, in a vertical direction Z, the first upper transistor UTa and a substrate 110 (e.g., a silicon, or other semiconductor, substrate). A first MDI region 130a is between, in the direction Z, the first lower transistor LTa and the first upper transistor UTa. Moreover, the second lower transistor LTb is between, in the direction Z, the second upper transistor UTb and the substrate 110, and a second MDI region 130b is between, in the direction Z, the second lower transistor LTb and the second upper transistor UTb.

A dielectric wall 134 is between, in the direction X, the first lower transistor LTa and the second lower transistor LTb. An etch-stop layer 132 may be between, in the direction X, the first MDI region 130a and the second MDI region 130b, and may be on a portion of an upper surface of the first lower transistor LTa and a portion of an upper surface of the second lower transistor LTb. The first upper channel layers 124a of the first upper transistor UTa and the second upper channel layers 124b of the second upper transistor UTb do not vertically overlap the etch-stop layer 132. In some embodiments, the etch-stop layer 132 may be integral with the dielectric wall 134. For example, the etch-stop layer 132 may contact an upper surface and/or side surfaces of the dielectric wall 134, and may include the same insulating material as the dielectric wall 134. As a result, an interface may not be visible/discernible between the etch-stop layer 132 and the dielectric wall 134.

Moreover, the etch-stop layer 132 may be integral with the MDI regions 130a, 130b. As an example, the etch-stop layer 132 and the MDI regions 130a, 130b may each be part of a middle isolation region 136 that is integral with the dielectric wall 134. The first MDI region 130a, the second MDI region 130b, and the etch-stop layer 132 may thus be referred to herein as first, second, and third portions, respectively, of the middle isolation region 136. The etch-stop layer 132 may contact a sidewall of the first MDI region 130a and a sidewall of the second MDI region 130b. As the etch-stop layer 132 and the MDI regions 130a, 130b may each include the same insulating material, however, no interface may be visible/discernible between the etch-stop layer 132 and the MDI regions 130a, 130b. For example, the insulating material of the etch-stop layer 132, the MDI regions 130a, 130b, and the dielectric wall 134 may be silicon nitride (e.g., Si₃N₄). In some embodiments, the insulating material (and thus the middle isolation region 136 and the dielectric wall 134) may be free of carbon and free of boron. Accordingly, the insulating material may be different from silicon boron carbonitride (e.g., SiBCN). According to some embodiments, the middle isolation region 136 and the dielectric wall 134 may be free of air gaps therein.

In some embodiments, the first lower transistor LTa and the second lower transistor LTb may be different types of MOSFETs. As an example, the first lower transistor LTa may be an n-type FET, and the second lower transistor LTb may be a p-type FET. In other embodiments, the first lower transistor LTa and the second lower transistor LTb may be the same type of MOSFET. For example, the first lower transistor LTa and the second lower transistor LTb may both be n-type FETs or may both be p-type FETs. According to some embodiments, the first upper transistor UTa and the second upper transistor UTb may be MOSFETs having types that are opposite to those of the first lower transistor LTa and the second lower transistor LTb, respectively. Moreover, each channel layer 122, 124 may be implemented by, for example, a nanosheet or nanowire.

For simplicity of illustration, only one forksheet stacked FET structure 102 is shown in FIG. 1A. According to some embodiments, however, the device 100 may include two, three, four, or more forksheet stacked FET structures 102.

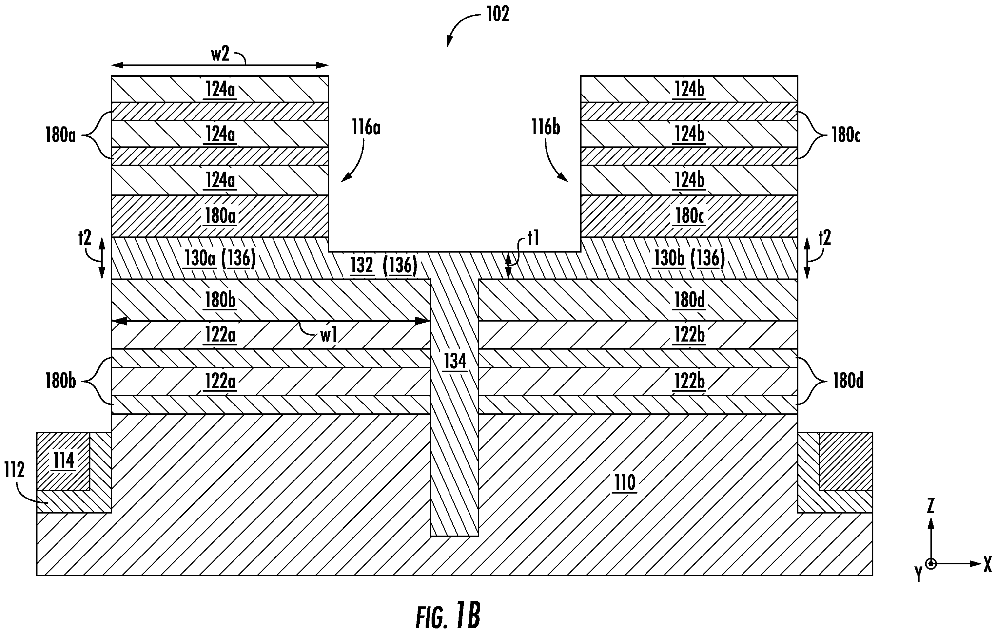

FIG. 1B is an example cross-sectional view of the forksheet stacked FET structure 102. As shown in FIG. 1B, the upper channel layers 124a, 124b may be narrower, in the direction X, than the lower channel layers 122a, 122b. Accordingly, the lower channel layers 122a, 122b may have a width w1, in the direction X, that is wider than a width w2, in the direction X, of the upper channel layers 124a, 124b. As a result, a portion of the first lower channel layers 122a is not vertically overlapped by the first upper channel layers 124a, and a portion of the second lower channel layers 122b is not vertically overlapped by the second upper channel layers 124b.

The etch-stop layer 132 may include a first portion that vertically overlaps the portion of the first lower channel layers 122a that is not vertically overlapped by the first upper channel layers 124a, and a second portion that vertically overlaps the portion of the second lower channel layers 122b that is not vertically overlapped by the second upper channel layers 124b. As used herein, the term "vertically overlap" refers to overlap in the vertical direction Z.

Moreover, the etch-stop layer 132 may have a thickness t1 that is thinner, in the vertical direction Z, than a thickness t2 of each of the MDI regions 130a, 130b. An upper portion of a sidewall of the first MDI region 130a may thus not be overlapped by the etch-stop layer 132 in the direction X. Likewise, an upper portion of a sidewall of the second MDI region 130b may not be overlapped by the etch-stop layer 132 in the direction X. According to some embodiments, the first MDI region 130a may have the same width w2 as the first upper channel layers 124a, and the second MDI region 130b may have the same width (e.g., the width w2) as the second upper channel layers 124b.

FIG. 1B also shows that the forksheet stacked FET structure 102 includes four conductive gates 180 (180a, 180b, 180c, 180d). A first upper conductive gate 180a may be on and between (e.g., in the vertical direction Z) the first upper channel layers 124a, and a first lower conductive gate 180b may be on and between (e.g., in the direction Z) the first lower channel layers 122a. A second upper conductive gate 180c may be on and between (e.g., in the direction Z) the second upper channel layers 124b, and a second lower conductive gate 180d may be on and between (e.g., in the direction Z) the second lower channel layers 122b.

For simplicity of illustration, portions of the gates 180a-180d are omitted from view in FIG. 1B. For example, the first upper gate 180a may include a vertical portion that is on a left sidewall of each of the first upper channel layers 124a. Likewise, the first lower gate 180b may include a vertical portion that is on a left sidewall of each of the first lower channel layers 122a. Moreover, the second upper gate 180c may include a vertical portion that is on a right sidewall of each of the second upper channel layers 124b, and the second lower gate 180d may include a vertical portion that is on a right sidewall of each of the second lower channel layers 122b.

For further simplicity of illustration, a gate insulation layer is omitted from view in FIG. 1B. It will be understood, however, that a gate insulation layer may extend between each first upper channel layer 124a and the first upper gate 180a, between each first lower channel layer 122a and the first lower gate 180b, between each second upper channel layer 124b and the second upper gate 180c, and between each second lower channel layer 122b and the second lower gate 180d. The gate insulation layers may wrap around the channel layers and may be thinner than the MDI regions 130a, 130b.

According to some embodiments, gate metals of the gates 180a-180d may vary based on whether they are for PMOS transistors or NMOS transistors. As an example, a gate metal of the first lower gate 180b may be the same as a gate metal of the second lower gate 180d if the lower gates 180b, 180d are both for the same type of transistor (e.g., both PMOS or both NMOS). On the other hand, if the lower gates 180b, 180d are for different types of transistors (e.g., one NMOS and one PMOS), then they may have different gate metals. PMOS and NMOS transistors may be provided by source/drain (S/D) regions comprising, for example, silicon germanium and silicon carbide, respectively.

In some embodiments, the direction X may be a channel-width direction of the channel layers 122, 124. For simplicity of illustration, S/D regions are omitted from view in FIG. 1B. It will be understood, however, that the S/D regions may be adjacent the gates 180a-180d in a second horizontal (i.e., lateral) direction Y, which may be perpendicular to the directions X and Z.

According to some embodiments, the dielectric wall 134 may extend into the substrate 110. A lower portion of the dielectric wall 134 may thus be in the substrate 110. An upper portion of the dielectric wall 134 may be on (e.g., may contact) a sidewall of each of the first lower channel layers 122a and a sidewall of each of the second lower channel layers 122b.

Moreover, an insulating layer 112 may be in a recess of the substrate 110. Another insulating layer 114 may also be in the recess and on the insulating layer 112. In some embodiments, vertical portions of the gates 180a-180d may vertically overlap the insulating layers 112, 114. The insulating layer 112 may comprise, for example, a nitride (e.g., silicon nitride), and the insulating layer 114 may comprise an oxide (e.g., silicon oxide). According to some embodiments, the insulating layer 112 may comprise the same insulating material as the dielectric wall 134 and the middle isolation region 136, and the insulating layer 114 may comprise a different insulating material from that of the dielectric wall 134 and the middle isolation region 136.

One or more other elements (e.g., one or more insulating layers) may be between, in the direction X, the first upper channel layers 124a and the second upper channel layers 124b, and above the etch-stop layer 132 in the direction Z. For simplicity of illustration, however, no other elements are shown between the first upper channel layers 124a and the second upper channel layers 124b.

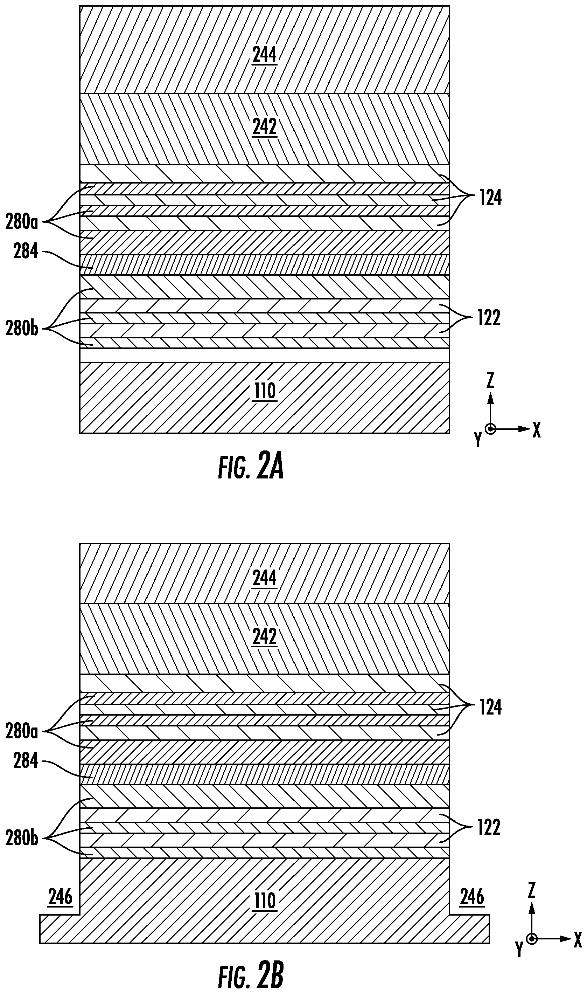

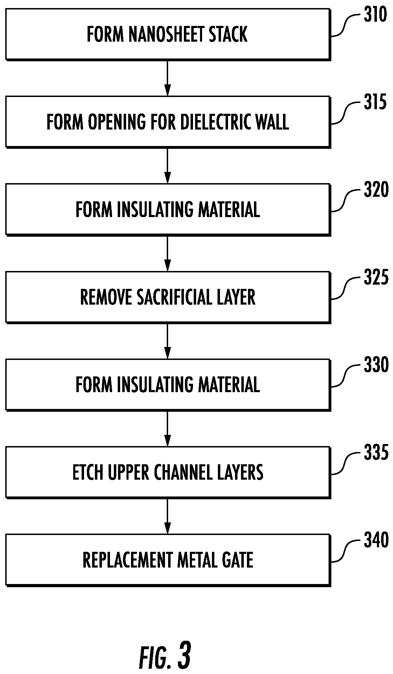

FIGs. 2A-2J are cross-sectional views illustrating operations of forming the forksheet stacked FET structure 102 of FIG. 1B, and FIG. 3 is a flowchart corresponding to the operations shown in FIGs. 2A-2J.

As shown in FIGs. 2A and 3, the operations may include forming (Block 310) stacks of semiconductor channel layers 122, 124 on a substrate 110. In some embodiments, the channel layers 122, 124 may be nanosheets, and the stacks may thus be nanosheet stacks. A lower stack comprises lower channel layers 122, and an upper stack comprises upper channel layers 124. The lower stack is separated from the upper stack by a sacrificial isolation layer 284. Moreover, sacrificial gate layers 280 may be alternately stacked on the substrate 110 with the channel layers 122, 124. The sacrificial gate layers 280 include upper sacrificial gate layers 280a that alternate with the upper channel layers 124, and lower sacrificial gate layers 280b that alternate with the lower channel layers 122. The sacrificial isolation layer 284 may be between a lowermost one of the upper sacrificial gate layers 280a and an uppermost one of the lower sacrificial gate layers 280b.

The upper stack and the lower stack each form part of the forksheet stacked FET structure 102. The lower channel layers 122 form part of lower transistors LTa, LTb (FIG. 1A) of the forksheet stacked FET structure 102, and the upper channel layers 124 form part of upper transistors UTa, UTb (FIG. 1A) of the forksheet stacked FET structure 102.

Though the plural term "stacks" is used in some examples herein for ease of differentiating between upper and lower channel layers, the singular term "stack" may also be used to describe the collective structure, as the upper channel layers 124 are stacked on top of the lower channel layers 122. Accordingly, the term "nanosheet stack" may refer to either (i) a stack that includes both the upper channel layers 124 and the lower channel layers 122, or (ii) a stack that includes one of only the upper channel layers 124 or only the lower channel layers 122 and is stacked with another stack that includes the other one of only the upper channel layers 124 or only the lower channel layers 122.

The channel layers 122, 124 are semiconductor layers that comprise, for example, silicon (e.g., polysilicon). In a subsequent process/operation, the upper sacrificial gate layers 280a may be replaced with first and second upper conductive gates 180a, 180c (FIG. 1B), and the lower sacrificial gate layers 280b may be replaced with first and second lower conductive gates 180b, 180d (FIG. 1B). Moreover, the sacrificial isolation layer 284 may be replaced with a middle isolation region 136 (FIG. 1B) in a subsequent process/operation.

The sacrificial gate layers 280 may comprise, for example, silicon germanium. Accordingly, the sacrificial gate layers 280 may have an etch selectivity relative to the channel layers 122, 124. The sacrificial gate layers 280 may also have an etch selectivity relative to the sacrificial isolation layer 284. For example, the sacrificial isolation layer 284 and the sacrificial gate layers 280 may each comprise silicon germanium, but with different concentrations of germanium. As an example, the sacrificial isolation layer 284 may have a higher concentration of germanium (e.g., 55%) than the sacrificial gate layers 280 (e.g., 25%).

In some embodiments, a lower mask layer 242 and an upper mask layer 244 may be formed on top of the upper channel layers 124. The lower mask layer 242 may comprise a different insulating material from that of the upper mask layer 244. For example, the lower mask layer 242 may comprise a nitride (e.g., silicon nitride), and the upper mask layer 244 may comprise an oxide (e.g., silicon oxide).

As shown in FIG. 2B, recesses 246 may be formed in the substrate 110 by narrowing, in the direction X, a stack comprising the mask layers 242, 244, the channel layers 122, 124, the sacrificial gate layers 280, and the sacrificial isolation layer 284, and etching portions of the substrate 110 that are on opposite sides of the stack. For example, an etch process may be performed with respect to both the stack and the substrate 110. Moreover, the etch process may reduce a thickness, in the vertical direction Z, of the upper mask layer 244.

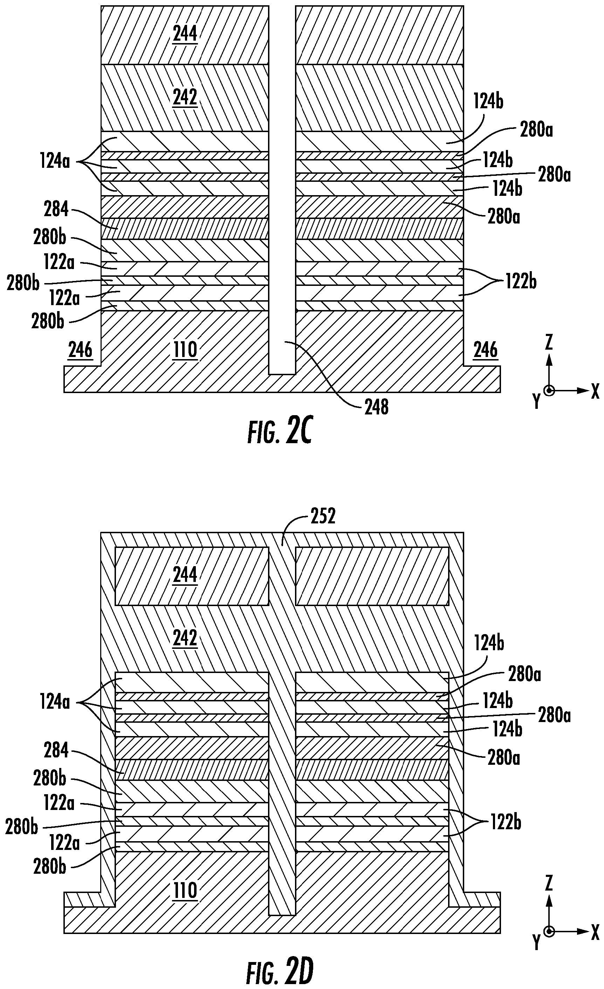

As shown in FIGs. 2C and 3, an opening 248 may be formed (Block 315) in the stack. In a subsequent process/operation, a dielectric wall 134 (FIG. 1B) will be formed in part of the opening 248. The opening 248 may thus be formed at a center point, in the direction X, of the stack, and can thereby separate the lower channel layers 122 into first lower channel layers 122a and second lower channel layers 122b, as well as separate the upper channel layers 124 into first upper channel layers 124a and second upper channel layers 124b. Accordingly, the opening 248 divides the stack shown in FIG. 2B into two stacks.

The opening 248 may be formed by, for example, a vertical etch process/operation. The vertical etch process/operation may include vertically etching through the sacrificial isolation layer 284, thereby dividing the sacrificial isolation layer 284 into two separate portions. Moreover, the vertical etch process/operation may, in some embodiments, etch a portion of the substrate 110 such that the opening 248 extends into the substrate 110.

As shown in FIGs. 2D and 3, an insulating material 252 may be formed (Block 320) in the opening 248 (FIG. 2C), in the recesses 246 (FIG. 2C), and on the stack. In some embodiments, the insulating material 252 may be formed by an insulating layer deposition/fill process/operation in the opening 248 and the recesses 246. For example, the insulating material 252 may comprise silicon nitride (e.g., Si₃N₄) and may be formed by a deposition/fill process/operation that fills the opening 248 and provides a thin insulating liner in the recesses 246, on top of the stack, and on sidewalls of the stack. Accordingly, portions of the insulating material 252 that are in the recesses 246, on top of the stack, and on sidewalls of the stack may provide a thin insulating liner. Moreover, the insulating material 252 may be free of carbon and free of boron.

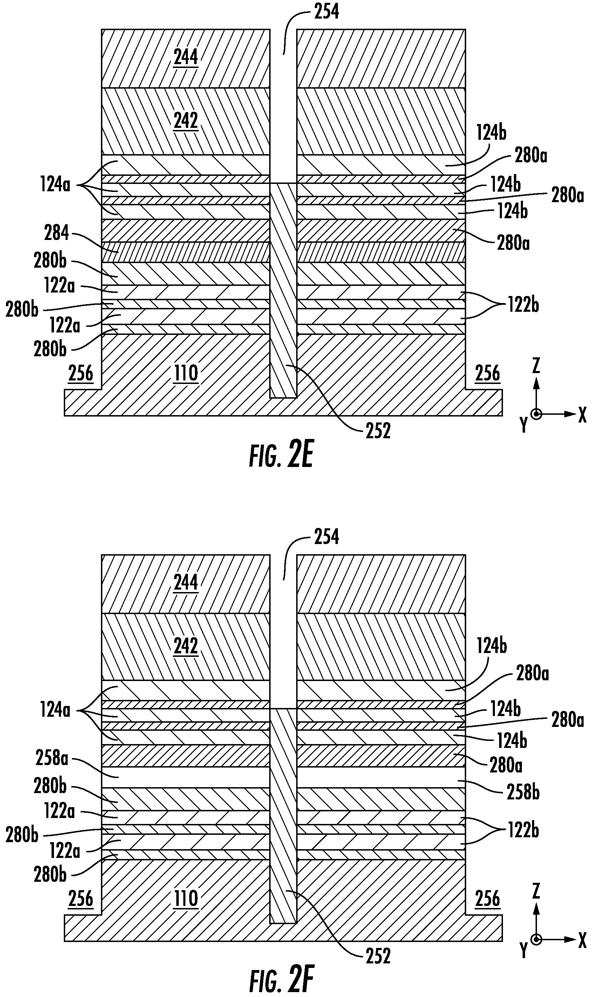

As shown in FIG. 2E, the insulating-liner portion of the insulating material 252 may be removed from the recesses 246 and the top and sidewalls of the stack. Moreover, a portion of the insulating material 252 that is between sidewalls of the mask layers 242, 244 may be removed, as well as a portion of the insulating material 252 that is between a sidewall of an uppermost one of the first upper channel layers 124a and a sidewall of an uppermost one of the second upper channel layers 124b. As a result, an opening 254 may be formed between the sidewalls of the mask layers 242, 244 and between the sidewall of the uppermost one of the first upper channel layers 124a and the sidewall of the uppermost one of the second upper channel layers 124b. A portion of the insulating material 252 that is between the first lower channel layers 122a and the second lower channel layers 122b may serve as the dielectric wall 134 that is shown in FIG. 1B.

As shown in FIGs. 2F and 3, the sacrificial isolation layer 284 (FIG. 2E) may be removed (Block 325), thereby forming a first opening 258a between the first upper channel layers 124a and the first lower channel layers 122a, and a second opening 258b between the second upper channel layers 124b and the second lower channel layers 122b. For example, the sacrificial isolation layer 284 may comprise a semiconductor material having an etch selectivity relative to the channel layers 122, 124 and the sacrificial gate layers 280, and thus may be removed by a selective-etch process/operation. The openings 258a, 258b may expose respective sidewalls of the insulating material 252.

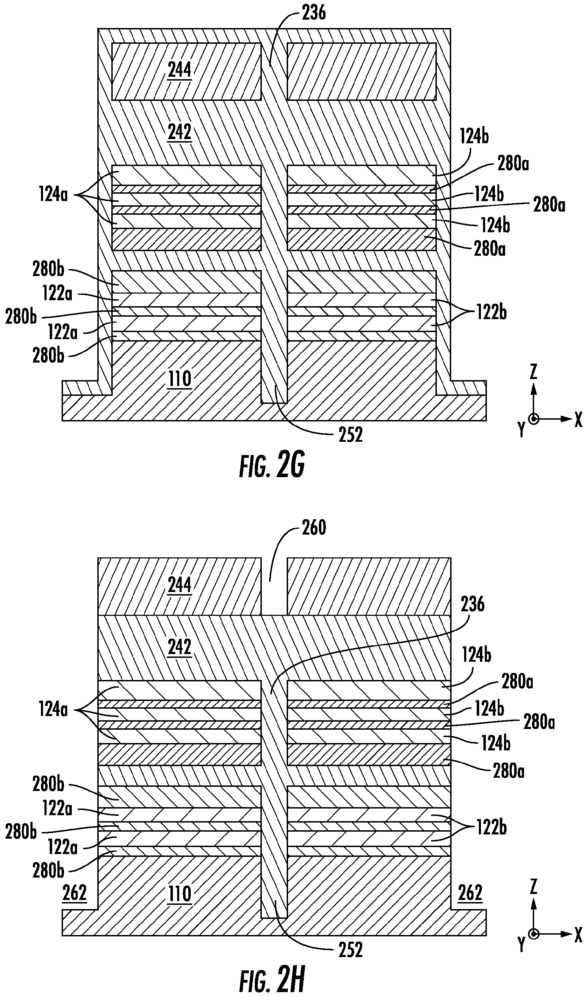

As shown in FIGs. 2G and 3, an insulating material 236 may be formed (Block 330) in the opening 254 (FIG. 2F) and in the openings 258a, 258b (FIG. 2F). As a result, the insulating material 236 may contact an upper surface of the insulating material 252 that was exposed through the opening 254, as well as the sidewalls of the insulating material 252 that were exposed through the openings 258a, 258b. In some embodiments, the insulating material 236 may also provide a thin insulating liner on the top and sidewalls of the stack. The insulating material 236 may comprise the same material as the insulating material 252, and therefore may not have a visible/discernible interface with the insulating material 252. As an example, the insulating material 236 may comprise silicon nitride (e.g., Si₃N₄) and may be formed by a deposition/fill process/operation. The deposition/fill process/operation may be referred to herein as an "MDI fill," as portions of the insulating material 236 that fill the openings 258a, 258b may serve as respective MDI regions and may be referred to herein as a "middle isolation region."

According to some embodiments, the insulating materials 236, 252 may play different roles even when they comprise the same material. For example, the insulating material 252 may help to sustain/support left and right nanosheet structures. Moreover, the insulating material 236 may serve as an etch-stop layer and may separate upper nanosheets from lower nanosheets.

As shown in FIG. 2H, the insulating-liner portion of the insulating material 236 may be removed from the top and sidewalls of the stack. As a result, openings 262 may be formed that expose portions of the substrate 110. Moreover, a portion of the insulating material 236 that is between sidewalls of the upper mask layer 244 may be removed, thereby forming an opening 260.

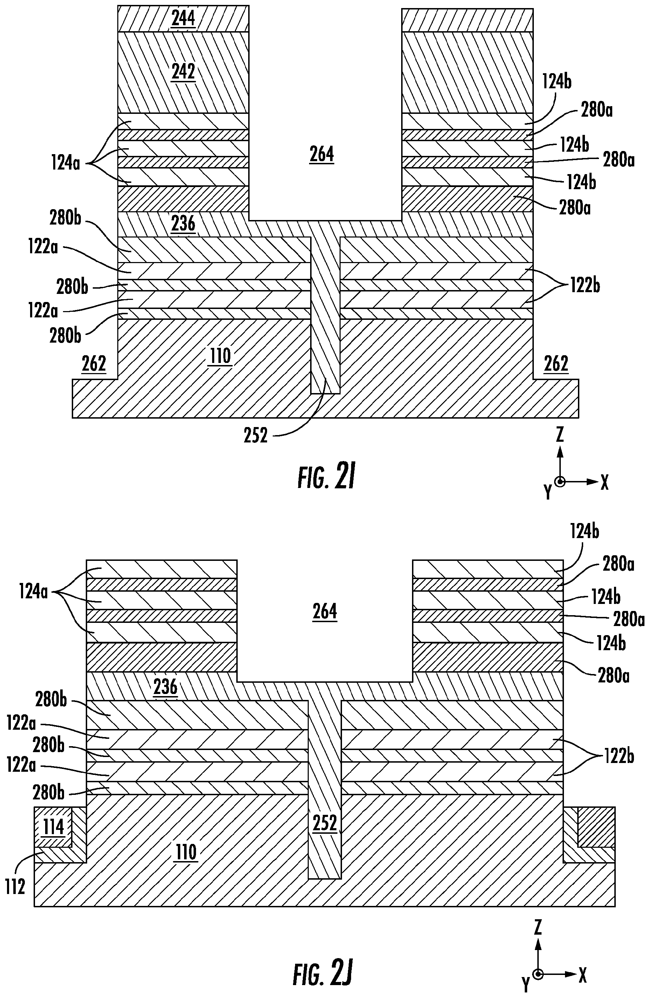

As shown in FIGs. 2I and 3, inner portions of the upper channel layers 124a, 124b may be etched (Block 335) while using a middle portion of the middle isolation region 236 as an etch-stop layer. At this time, as an example, a new mask layer (not shown) may be formed over the upper mask layer 244 and then may be used as an etch mask to remove portions of sidewalls of the upper mask layer 244, in which the new mask layer (not shown) may define a pattern corresponding an opening 264. As a result, the upper channel layers 124a, 124b may be narrowed in the direction X and may have the opening 264 therebetween. The narrowed upper channel layers 124a, 124b are narrower than the lower channel layers 122a, 122b. Also, control of a depth, in the vertical direction Z, of the opening 264 is enhanced by the middle (etch-stop) portion of the middle isolation region 236.

According to some embodiments, the middle (etch-stop) portion of the middle isolation region 236 may be etched such that it is thinner, in the vertical direction Z, than outer portions of the middle isolation region 236 that serve as MDI regions. The middle portion of the middle isolation region 236 may thus provide the etch-stop layer 132 that is shown in FIG. 1B. The lower sacrificial gate layers 280b and the lower channel layers 122a, 122b may not be exposed by the etching, and thus may be protected from damage that might otherwise occur if the middle (etch-stop) portion of the middle isolation region 236 were not present.

A first outer portion of the middle isolation region 236 is between the first lower channel layers 122a and the first upper channel layers 124a, and a second outer portion of the middle isolation region 236 is between the second lower channel layers 122b and the second upper channel layers 124b. The first and second outer portions of the middle isolation region 236 may provide the MDI regions 130a, 130b that are shown in FIG. 1B.

Uppermost surfaces of the first and second outer portions of the middle isolation region 236 are not exposed by the opening 264. An uppermost surface of the middle (etch-stop) portion of the middle isolation region 236, however, is exposed by the opening 264. In some embodiments, the upper mask layer 244 may be thinned, in the vertical direction Z, while, forming the opening 264.

As shown in FIG. 2J, the mask layers 242, 244 (FIG. 2I) may be removed, thereby exposing an upper surface of the uppermost one of the first upper channel layers 124a and an upper surface of the uppermost one of the second upper channel layers 124b. Moreover, a shallow-trench-isolation (STI) process may be performed. The STI process may include forming an insulating layer 112 in the openings 262 (FIG. 2I) and then forming another insulating layer 114 on the insulating layer 112. As an example, the insulating layer 112 may be formed by depositing a thin silicon nitride liner in the openings 262, and the insulating layer 114 may be formed by depositing an oxide (e.g., silicon oxide) on the thin silicon nitride liner.

In some embodiments, S/D regions of the device 100 (FIG. 1A) may be formed by epitaxial growth. For example, lower S/D regions may be epitaxially grown from the lower channel layers 122a, 122b, and upper S/D regions may be epitaxially grown from the upper channel layers 124a, 124b. According to some embodiments, the channel layers 122, 124 may comprise silicon, and the lower S/D regions and/or the upper S/D regions may comprise silicon, silicon carbide, or silicon germanium. Moreover, the S/D regions may be formed after narrowing the upper channel layers 124a, 124b, and thus after forming the etch-stop layer 132 and the MDI regions 130a, 130b. For simplicity of illustration, the S/D regions are omitted from view in the drawings.

As shown in FIG. 3, a gate-forming process, such as a replacement-metal-gate (RMG) process, may be performed (Block 340) after narrowing the upper channel layers 124a, 124b. For example, the gate-forming process may be performed after forming the S/D regions. The gate-forming process may include removing the sacrificial gate layers 280 from between the channel layers 122, 124, as the sacrificial gate layers 280 may have an etch selectivity relative to the channel layers 122, 124. Removal of the sacrificial gate layers 280 forms openings between the channel layers 122, 124.

The gate-forming process may also include forming first through fourth conductive gates 180a-180d (FIG. 1B) in the openings. In some embodiments, the first conductive gate 180a may comprise a first metal, and the second conductive gate 180b may comprise a second metal that is different from the first metal. Likewise, the third conductive gate 180c may comprise a different metal from that of the fourth conductive gate 180d. Moreover, the first conductive gate 180a may comprise a different metal from that of the third conductive gate 180c and/or the fourth conductive gate 180d. Similarly, the second conductive gate 180b may comprise a different metal from that of the fourth conductive gate 180d and/or the third conductive gate 180c. Though omitted from view in the drawings for simplicity of illustration, gate insulation layers may, according to some embodiments, be formed between the conductive gates 180 and the channel layers 122, 124.

Transistor devices 100 (FIG. 1A) according to embodiments herein may provide a number of advantages. These advantages include protecting lower-transistor regions of a forksheet structure from over-etching. For example, a forksheet stacked FET structure 102 (FIG. 1A) may include an etch-stop layer 132 (FIG. 1A) that can protect underlying first and second lower transistors LTa, LTb (FIG. 1A) of the forksheet stacked FET structure 102 from over-etching when etching upper channel layers 124 (FIG. 1A) of the forksheet stacked FET structure 102. The etch-stop layer 132 may comprise the same insulating material as, and be integral with (i.e., be in contact and have no visible/discernible interface with), MDI regions 130a, 130b (FIG. 1A) and a dielectric wall 134 (FIG. 1A) of the forksheet stacked FET structure 102. Conventional forksheet structures lack the protection provided by the etch-stop layer 132 that is integral with the MDI regions 130a, 130b and the dielectric wall 134.

It is also advantageous that the etch-stop layer 132 and the MDI regions 130a, 130b may be formed relatively easily together with the dielectric wall 134. As an example, the etch-stop layer 132 and the MDI regions 130a, 130b may be formed without needing a different insulating material from that of the dielectric wall 134. For example, the etch-stop layer 132, the MDI regions 130a, 130b, and the dielectric wall 134 may each include silicon nitride and may be free of carbon and boron (and thus do not require forming silicon boron carbonitride). Moreover, the etch-stop layer 132 may be formed concurrently with the MDI regions 130a, 130b and/or the dielectric wall 134, and thus may not require numerous and/or complicated additional process steps (beyond operations used to form the dielectric wall 134). Also, by using the operations shown in FIGs. 2C-2I, the dielectric wall 134 may be formed to be free of air gaps therein, which may be in contrast with conventional forksheet dielectric walls.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive, and the appended claims are intended to cover all such modifications, enhancements, and other embodiments, which fall within the scope of the present invention. Thus, to the maximum extent allowed by law, the scope is to be determined by the broadest permissible interpretation of the following claims and their equivalents, and shall not be restricted or limited by the foregoing detailed description.

## Claims

1. A forksheet stacked field-effect transistor, FET, device comprising:
a first stacked FET (116a) comprising a first lower FET (LTa) and a first upper FET (UTa) that is on top of the first lower FET (LTa);
a second stacked FET (116b) that is adjacent the first stacked FET (116a), the second stacked FET (116b) comprising a second lower FET (LTb) and a second upper FET (UTb) that is on top of the second lower FET (LTb);
a dielectric wall (134) that is between the first lower FET (LTa) and the second lower FET (LTb); and
a middle isolation region (136) comprising a first portion and a second portion,
wherein the first portion is a first middle dielectric isolation, MDI, region (130a) that is between the first lower FET (LTa) and the first upper FET (UTa), and
wherein the second portion is a second MDI region (130b) that is between the second lower FET (LTb) and the second upper FET (UTb).

2. The forksheet stacked FET device of Claim 1,
wherein the second stacked FET (116b) is adjacent the first stacked FET (116a) in a horizontal direction,
wherein the dielectric wall (134) is between the first lower FET (LTa) and the second lower FET (LTb) in the horizontal direction,
wherein the first MDI region (130a) is between the first lower FET (LTa) and the first upper FET (UTa) in a vertical direction,
wherein the second MDI region (130b) is between the second lower FET (LTb) and the second upper FET (UTb) in the vertical direction, and
wherein the forksheet stacked FET device (100) further comprises a third portion that is between, in the horizontal direction, the first MDI region (130a) and the second MDI (130b) region.

3. The forksheet stacked FET device of Claim 2, wherein the third portion is an etch-stop layer (132).

4. The forksheet stacked FET device of Claim 2 or 3,
wherein the first lower FET (LTa) and the first upper FET (UTa) each comprise semiconductor channel layers (122a, 124a),
wherein the semiconductor channel layers (122a) of the first lower FET (LTa) are wider, in the horizontal direction, than the semiconductor channel layers (124a) of the first upper FET (UTa), and
wherein the third portion vertically overlaps a portion of the semiconductor channel layers (122a) of the first lower FET (LTa) that is not vertically overlapped by the semiconductor channel layers (124a) of the first upper FET (UTa).

5. The forksheet stacked FET device of any one of Claims 2 to 4, wherein the third portion is thinner, in the vertical direction, than the first MDI region (130a) and/or than the second MDI region (130b).

6. The forksheet stacked FET device of any one of Claims 2 to 5, wherein the third portion, the dielectric wall (134), the first MDI region (130a), and the second MDI region (130b) each comprise the same insulating material.

7. The forksheet stacked FET device of Claim 6, wherein the insulating material comprises silicon nitride.

8. The forksheet stacked FET device of any one of Claims 2 to 7,
wherein the second lower FET (LTb) and the second upper FET (UTb) each comprise semiconductor channel layers (122b, 124b),
wherein the semiconductor channel layers (122b) of the second lower FET (LTb) are wider, in the horizontal direction, than the semiconductor channel layers (124b) of the second upper FET (UTb), and
wherein the third portion vertically overlaps a portion of the semiconductor channel layers (122b) of the second lower FET (LTb) that is not vertically overlapped by the semiconductor channel layers (124b) of the second upper FET (UTb).

9. The forksheet stacked FET device of any one of Claims 2 to 8,
wherein the first upper FET (UTa) comprises semiconductor channel layers that do not vertically overlap the third portion, and/or
wherein the first lower FET (LTa) and the second lower FET (LTb) each comprise semiconductor channel layers that are vertically overlapped by the etch-stop layer (132).

10. The forksheet stacked FET device of any one of Claims 1 to 9, wherein the middle isolation region (136) is integral with the dielectric wall (134) and/or
wherein the middle isolation region (136) is free of carbon and free of boron.

11. A method of forming a forksheet stacked field-effect transistor, FET, device, the method comprising:
forming a dielectric wall (134) and a middle isolation region (236) in a stack of semiconductor channel layers; and
etching (335) upper ones of the semiconductor channel layers while using a middle portion of the middle isolation region (236) as an etch-stop layer,
wherein the dielectric wall (134) separates first lower semiconductor channel layers (122a) among lower ones of the semiconductor channel layers from second lower semiconductor channel layers (122b) among the lower ones of the semiconductor channel layers,
wherein a first outer portion of the middle isolation region (236) is between the first lower semiconductor channel layers (122a) and first upper semiconductor channel layers (124a) among the upper ones of the semiconductor channel layers, and
wherein a second outer portion of the middle isolation region (236) is between the second lower semiconductor channel layers (122b) and second upper semiconductor channel layers (124b) among the upper ones of the semiconductor channel layers.

12. The method of Claim 11, wherein forming the dielectric wall (134) comprises:
vertically etching (315) the upper ones of the semiconductor channel layers and the lower ones of the semiconductor channel layers, thereby forming a first opening (248) that divides the stack into two stacks; and
forming (320) an insulating material (252) in the first opening (248).

13. The method of Claim 12, wherein forming the middle isolation region (236) comprises:
removing (325) a sacrificial layer (284) that is between the upper ones of the semiconductor channel layers and the lower ones of the semiconductor channel layers, thereby forming a second opening (258a); and
forming the insulating material (252) in the second opening (258a).

14. The method of Claim 13,
wherein vertically etching (315) comprises vertically etching through the sacrificial layer (284), and
wherein removing the sacrificial layer (284) is performed after forming the insulating material (252) in the first opening (248).

15. The method of any one of Claims 11 to 14,
wherein the first outer portion of the middle isolation region (236) is a first middle dielectric isolation, MDI, region (130a), the second outer portion of the middle isolation region (236) is a second MDI region (130b), and the etch-stop layer (132) is integral with the dielectric wall (134), the first MDI region (130a), and the second MDI region (130b), and/or
wherein etching the upper ones of the semiconductor channel layers comprises narrowing the upper ones of the semiconductor channel layers such that the first upper semiconductor channel layers (124a) are narrower than the first lower semiconductor channel layers (122a) and the second upper semiconductor channel layers (124b) are narrower than the second lower semiconductor channel layers (122b).
